# EUROPÄISCHE PATENTSCHRIFT

(11) **EP 2 859 657 B1**
(45) Veröffentlichungstag und Bekanntmachung des Hinweises auf die Patenterteilung: **11.12.2019**
(21) Anmeldenummer: 13726749.8
(22) Anmeldetag: 29.05.2013
(51) Int. Cl.: H03K 17/955, H03K 17/96

(54) **KAPAZITIVE SENSORANORDNUNG ZUR SCHALTUNG EINER TÜRÖFFNUNG AN EINEM KRAFTFAHRZEUG**
CAPACITIVE SENSOR ARRANGEMENT FOR SWITCHING A DOOR OPENING ON A MOTOR VEHICLE
ENSEMBLE CAPTEUR CAPACITIF POUR ACTIONNER UNE OUVERTURE DE PORTE AU NIVEAU D'UN VÉHICULE AUTOMOBILE

(30) Priorität: 06.06.2012 DE 102012104915
(43) Veröffentlichungstag der Anmeldung: 15.04.2015
(73) Patentinhaber: Huf Hülsbeck & Fürst GmbH & Co. KG, 42551 Velbert (DE)
(72) Erfinder: SCHINDLER, Mirko, 42549 Velbert (DE); HELLER, Norbert, 47929 Grefrath (DE); VAN GASTEL, Peter, 42699 Solingen (DE); PESCHL, Andreas, 42555 Velbert (DE)
(74) Vertreter: Zenz Patentanwälte Partnerschaft mbB
(86) Internationale Anmeldenummer: PCT/EP2013/061082
(87) Internationale Veröffentlichungsnummer: WO 2013/182466

(56) Entgegenhaltungen:
- WO-A1-01/08925
- WO-A1-2014/032988
- DE-A1-102010 002 559

## Beschreibung

Die Erfindung betrifft eine kapazitive Sensoranordnung mit einer Sensorelektrode, mit deren Hilfe das Eindringen eines Objekts in einen Raum vor der Sensorelektrode erfasst wird. Eine mit der Sensorelektrode gekoppelte Steuer- und Auswerteschaltung erfasst eine Änderung der Kapazität der Sensorelektrode gegenüber einem Referenzpotential, indem sie die Sensorelektrode mit einer vorgegebenen Frequenz periodisch auf- und entlädt und wenigstens einen Parameter eines vom periodischen Laden und Entladen der Sensorelektrode abhängigen Strom- oder Spannungsverlaufs zur Erfassung der Kapazitätsänderung auswertet. Die Sensorelektrode reagiert dabei auf Annäherungen bzw. Berührungen von Objekten durch eine Kapazitätsänderung des aus der Sensorelektrode und dem Objekt gebildeten Kondensators. Dies lässt sich im Kern darauf zurückführen, dass die Kapazität eines Kondensators von seinem Plattenabstand abhängt. Im Regelfall erhöht sich dessen Kapazität je näher das Objekt der Sensorelektrode kommt.

Eine kapazitive Sensoranordnung mit einer Sensorelektrode, mit deren Hilfe die Annäherung eines Objekts erfasst werden soll, und mit einer mit der Sensorelektrode gekoppelten Steuer- und Auswerteschaltung, die eine Änderung der Kapazität der Sensorelektrode gegenüber Masse erfasst, indem sie die Sensorelektrode mit einer vorgegebenen Frequenz periodisch wiederholt mit einer Betriebsspannung koppelt und wenigstens einen Parameter eines vom periodischen Laden und Entladen der Sensorelektrode abhängigen Strom- oder Spannungsverlaufs zur Erfassung der Kapazitätsänderung auswertet, ist beispielsweise aus dem US-Patent 5,730,165 bzw. der entsprechenden Patentschrift DE 196 81 725 B4 bekannt. Der Parameter eines vom periodischen Laden und Entladen der Sensorelektrode abhängigen Strom- oder Spannungsverlaufs ist dabei eine über einem Kondensator messbare Spannung, die von der auf dem Kondensator angesammelten Ladung abhängt, wobei diese Ladung dadurch angesammelt wird, dass periodisch wiederholt die Sensorelektrode durch Koppeln mit der Betriebsspannung aufgeladen und anschließend durch Koppeln mit dem Kondensator über diesen entladen wird. Ein anderer derartiger kapazitiver Sensor ist aus der Patentschrift EP 1 339 025 B1 bekannt.

Aus der DE 10 2010 002 559 A1 ist eine kapazitive Sensoranordnung bekannt, bei welcher eine segmentierte Sensorelektrode eingesetzt wird.

Die WO 0108925 A1 offenbart eine kapazitive Sensoranordnung mit einer Flachelektrode, die auf die Innenseite eines Stoßfängers aufzukleben ist. Die Elektrode weist Abschnitte unterschiedlicher Breite auf, um insbesondere die Endabschnitte der Elektrode sensitiver als den Mittelabschnitt auszubilden.

Bei kapazitiven Sensoren werden Kapazitätsänderungen auch als Variationen der Auflade- und/oder Entladezeit der Kapazität einer Sensorelektrode ermittelt. Beispielsweise arbeitet der Sensor nach dem Ladungstransferprinzip. Eine Auswerteelektronik nach dem Ladungstransferprinzip benötigt dabei wenigstens einen Referenzkondensator welcher turnusmäßig aufgeladen wird, wobei die Aufladezeit bestimmt wird und als Referenzzeitspanne für die Auswertung von Annäherungen oder Berührungen eines Objektes verwendet wird. Es werden also Änderungen der Aufladezeit des Referenzkondensators ausgewertet, die durch Annäherungen eines Objektes an die Sensorelektrode modifiziert werden.

Derartige Sensorelektroden können verwendet werden, um eine Tür oder Klappe eines Kraftfahrzeugs, z.B. die Heckklappe zu betätigen. Dazu können Sensorelektroden verwendet werden, welche die Annäherung eines Körperteils, z.B. eine Schwenkbewegung eines Beines unter den Stoßfänger, detektieren und in ein Kommando zum Öffnen oder Schließen der Heckklappe an eine Steuereinrichtung im Kraftfahrzeug weiterleiten. Es sind auch Sensorelektroden mit Flachbandkabel bekannt, z.B. aus der DE 10 2010 027 872.

Ein Problem mit den bekannten Einrichtungen besteht darin, dass die Sensorelektroden an eine Vielzahl von FahrzeugGeometrien anzupassen sind. Die Elektroden müssen jedoch jederzeit in möglichst geringem Abstand zu dem Detektionsbereich angeordnet werden und außerdem eine möglichst hohe Sensitivität aufweisen.

Aufgabe der Erfindung ist es daher, eine hinsichtlich der Flexibilität optimierte Sensoranordnung bereitzustellen, welche die Fehlerfassungen von Betätigungsanforderungen reduziert und welche raumsparend und flexibel am Fahrzeug anzubringen ist.

Erfindungsgemäß wird diese Aufgabe durch eine kapazitive Sensoranordnung mit den Merkmalen des Anspruchs 1 gelöst.

Die erfindungsgemäße Sensoranordnung zur Erfassung von Bewegungsgesten an einem Kraftfahrzeug hat wenigstens eine kapazitive Sensorelektrode und wenigstens eine mit der Sensorelektrode gekoppelte Steuer- und Auswerteeinrichtung, welche eine Änderung der Kapazität der Sensorelektrode erfasst. Die Sensorelektrode ist als langgestreckte Flachelektrode ausgebildet, wobei sich in Längsrichtung erste, breitere Elektrodenabschnitte mit einer ersten Flächenbreite mit zweiten, weniger sensitiven Abschnitten einer zweiten, geringeren Flächenbreite abwechseln, so dass abschnittsweise durchgehend leitende, jedoch unterschiedlich sensitive Elektrodenflächen mit unterschiedlichen Abmessungen gebildet sind. Die abwechselnden Bereiche weisen paarweise einheitliche Abmessungen auf, so dass alle breiteren Abschnitte einheitlich ausgebildet sind und alle schmaleren Abschnitte einheitlich ausgebildet sind.

Die zweiten Abschnitte mit geringerer Breite weisen eine geringere Länge auf als die ersten Abschnitte.

Die erfindungsgemäße kapazitive Sensoranordnung umfasst demnach eine sich entlang einer ersten Koordinatenlinie erstreckende erste Sensorelektrode, mit deren Hilfe das Eindringen eines Objekts in einen Raum vor der ersten Sensorelektrode erfasst werden soll. Die Koordinatenlinie ist beispielsweise eine gerade Koordinatenlinie eines kartesischen Koordinatensystems; sie kann aber auch im Raum gekrümmt sein. Zur Unterscheidung der Raumrichtungen wird im Weiteren davon ausgegangen, dass die Elektrode sich mit ihrer größten Ausdehnung, der Längserstreckung in Richtung einer z-Achse erstreckt. Die Sensorelektrode besteht aus einem elektrisch leitenden Material oder einer Kombination von elektrisch leitenden Materialien und ist als Flachelektrode ausgebildet. Dies bedeutet, dass die Elektrode in einer Raumorientierung (hier als x-Achse definiert) eine Stärke aufweist, die wenigstens eine Größenordnung geringer ist als die maximale Erstreckung in den beiden dazu senkrechten Raumrichtungen (also der z-Achse und der Y-Achse). Entsprechend dieser Definition dehnt sich die Elektrode als flächige Elektrode in der yz-Ebene aus, während sie in der x-Richtung nur geringe Dicke aufweist. Die Flachelektrode weist außerdem Bereiche unterschiedlicher Flächenausdehnung in Richtung der Längserstreckung auf. Bereiche mit eingeschnürter Flächenausdehnung wechseln sich mit Bereichen vergrößerter Flächenausdehnung ab. Die Elektrodenfläche entlang der Längserstreckung ist also in verschiedenen Abschnitten unterschiedlich.

Zumindest die ersten Abschnitte der Elektrode sind als integrale Leiterabschnitte ausgeführt. Die zweiten Abschnitte können, wie unten beschrieben, ebenfalls integral ausgebildet sein. Dann kann die gesamte Elektrode z.B. durch stanzen oder lasern aus einem Leiterblech gebildet sein. Die zweiten Abschnitte können jedoch auch aus anderen elektrisch leitenden Kopplungsmitteln gebildet sein (z.B. auch mehradrig).

Die Bereiche geringerer Flächenbreite, also geringerer Breite quer zur Längserstreckung, sind leichter Verformbar als die Bereiche mit größerer Flächenbreite.

Mit den Vergleichsbezeichnungen "größer" und "geringer" oder "kleiner" sollen die Verhältnisse der Abmessungen untereinander bestimmt werden. Es soll also gesagt werden, dass die ersten Abschnitte breiter sind als die zweiten Abschnitte und die erste Verformbarkeit geringer ist als die zweite Verformbarkeit. Wesentlich ist, dass gezielt Bereiche mit größerer Verformbarkeit in der Flachelektrode gebildet sind, welche eine Flexibilität der Flachelektrode verbessern und die Anpassung des Elektrodenverlaufs an Fahrzeugkonturen erlaubt.

Eine verformbare, flache und elektrisch isolierende Ummantelung der Sensorelektrode ist zum Umschließen der Elektrode gebildet.

Durch diese Bauart wird einerseits eine sehr flache und platzsparende Elektrode gebildet. Außerdem wirkt die Elektrode mit ihrer Formgebung des durchgehenden Leiters ähnlich wie eine Zusammenschaltung von Kondensatorplatten unterschiedlicher Größe. Durch die verjüngten Abschnitte (kleinere Kondensatorplatten) werden die Bereiche größerer Flächenausdehnung (größerer Kondensatorplatten) verbunden. Da die Flächenbereiche elektrisch leitend verbunden sind, findet grundsätzlich ein Potenzialausgleich auf der Elektrode und ein Ausgleich der Flächenladung statt. Entsprechend reagieren die Bereiche größerer flächiger Ausdehnung stärker als die verjüngten Bereiche auf Annäherungen.

Durch die flächige Gestaltung wird außerdem eine optimierte Ausrichtung der Elektrode erreicht. Die Elektrode wird mit ihrer flächigen Seite in Richtung des Detektionsbereiches gerichtet. Diese Empfangsfläche oder Wirkungsfläche ist dann effektiver einsetzbar als bisherige Rundelektroden, da die Kondensatorplatte (Flachseite der Flachelektrode) auf den Detektionsbereich ausgerichtet wird.

Die Gesamtsensitivität der Elektrode wird gegenüber den bisher häufig verwendeten Kabelelektroden (z.B. Koaxialkabel) verbessert, was in der flächigen Ausbildung und optimierten Orientierung begründet ist. Während herkömmliche Flachelektroden jedoch oft nicht flexibel in wenigstens einer Richtung quer zu ihrer Längserstreckung waren, ist die erfindungsgemäße Flachelektrode dank der verjüngten oder schmaleren Bereiche in ihrer Flexibilität stark verbessert.

Die breiteren Bereiche können wiederum dank der durch die schmalen Bereiche vermittelten Flexibilität breiter ausgeführt werden als bei Verwendung einer gleichförmigen Flachelektrode. Dies überkompensiert die Sensitivitätsverluste in den schmalen Bereichen. Die erfindungsgemäße Elektrode ist sowohl besonders sensitiv als auch besonders Flexibel.

Das umgebende verformbare Material schützt vor Umwelteinflüssen und Kontakt mit elektrisch leitenden Bauteilen. Außerdem kann die Ummantelung eine Kraftverteilung bei Verformung der Elektrode bewirken, welche Knicken der Elektrode oder ungleichmäßigen Verformungen vorbeugt. Die Ummantelung kann dafür insbesondere eng an der Elektrode anliegen, was z.B. durch Umspritzen, einschrumpfen oder gemeinsames Extrudieren mit der flachen Elektrode als Seele erreicht wird. Entsprechende Verfahren und zugehörige Materialien sind in der Technik z.B. im Bereich der Türdichtungen bekannt. Hierzu wird beispielhaft auf die DE 10 2009 021 225 verwiesen.

Die ummantelte Elektrode ist einfach an die Einpassung in verschiedenen Kraftfahrzeugen anpassbar. Die verjüngten Bereiche lassen sich leicht Verformen und die Elektrode ist entlang einer 3D-Raumlinie im Heckbereich anzuordnen. Das verformbare Ummantelungsmaterial vollzieht die Verformungen mit, ohne zu brechen oder zu reißen.

Die erfindungsgemäße Elektrode kann als Längenhalbzeug gefertigt werden und ist danach grundsätzlich auf eine gewünschte Länge kürzbar.

Um die funktionalen Vorteile der erfindungsgemäßen Elektrode zu erläutern wird davon ausgegangen, dass eine mit der Sensorelektrode gekoppelte Steuer- und Auswerteschaltung vorhanden ist. Diese erfasst eine Änderung der Kapazität der Sensorelektrode gegenüber einem Referenzpotential, indem sie die erste Sensorelektrode mit einer vorgegebenen Frequenz periodisch auf- und entlädt und wenigstens einen Parameter eines vom periodischen Laden und Entladen der ersten Sensorelektrode abhängigen Strom- oder Spannungsverlaufs zur Erfassung der Kapazitätsänderung auswertet. Das periodische Auf- und Entladen führt sie beispielsweise aus, indem sie die Sensorelektrode mit der vorgegebenen Frequenz periodisch wiederholt mit einem vorgegebenen Potential, beispielsweise dem Betriebsspannungspotenzial, koppelt. Der Spannungsverlauf kann beispielsweise der Spannungsverlauf am Anschluss der ersten Sensorelektrode sein. Der Parameter kann beispielsweise eine Spannung, die über einem Ladung ansammelnden Kondensator gemessen wird, oder eine bestimmte Anzahl von Perioden des Ladens und Entladens bis zum Überschreiten einer Schaltschwelle durch eine an der ersten Sensorelektrode gemessene Spannung sein.

Die erfindungsgemäße Flachelektrode weist entlang ihrer Erstreckung Bereiche mit unterschiedlicher kapazitiver Sensitivität auf, wie oben beschrieben. Ein Körperteil, welches entlang der Sensorelektrode bewegt wird, erzeugt je nach Position entsprechend unterschiedliche Signale in der Auswerteeinrichtung. Diese Einrichtung erlaubt daher die Detektion einer Annäherung und außerdem eine Detektion einer Bewegung entlang der erfindungsgemäß geformten Elektrodenanordnung durch wiederholtes Abfragen dieser geformten Elektrodenanordnung, z.B. alle 5ms bis 15ms. Dadurch können Bewegungen, welche eine Bedienungsgeste darstellen von anderen Bewegungen sicherer unterschieden werden. Insbesondere ist zu überwachen, ob die zeitliche Folge von Kapazitätswerten charakteristische Veränderungen aufweist, z.B. Wendepunkte.

Eine vorgegebene Geste eines Benutzers, z.B. ein angetäuschter Kick unter den Stossfänger, soll zu einem Öffnungs- oder Schließvorgang führen. Dazu wird die Sensorelektrode abgefragt, ob das zeitliche Signalmuster charakteristisch für eines solche Bewegung ist, im genannten Beispiel also eine Annäherung des Unterschenkels eines Benutzers detektiert und zu ansteigenden Signalwerten führt.

Die Länge der Abschnitte verschiedener Breite ist von der Anwendung abhängig. Um die gewünschte Flexibilität sicherzustellen werden die verjüngten Bereiche, also der Abstand zwischen den breiteren Bereich zu einigen mm bis einigen cm gewählt. Um die gewünschte Flexibilität zu erreichen, sind die Bereiche mit geringerer Breite deutlich weniger lang als die Bereiche mit größerer Breite und damit höherer Sensitivität.

Die isolierende und verformbare Ummantelung weist in einer bevorzugten Ausführungsform äußere Markierungen auf, welche die Lage der breiteren und der Verjüngten Bereiche entlang der Längserstreckung markieren. Dadurch kann die in langen Stücken produzierte Elektrode (z.B. durch einen Extrusionsvorgang) in passende Abschnitte geteilt werden. Die Bereiche geringer Breite eignen sich dabei insbesondere als Trennstellen. An diesen Trennstellen kann die Kontaktierung mit Klemmen oder gekrimpten Mitteln vorgenommen werden.

In diesem Zusammenhang sind bei der Sensorelektrode Bereiche erster Art mit einheitlichen Abmessungen ausgebildet, so dass alle breiteren Abschnitte einheitlich ausgebildet sind. Vorzugsweise sind auch alle schmaleren Abschnitte einheitlich ausgebildet sind. Dies ermöglicht eine Auftrennung der Elektroden in gewünschter Länge, ohne auf die konkrete Art des Breiten Abschnitts zu achten.

An dieser Stelle ist anzumerken, dass es bei anwendungsspezifisch gefertigten Elektroden auch sein kann, dass breitere Abschnitte verschiedener Längenabmessung realisiert werden, z.B. um die schmaleren Bereiche auf solche Abschnitte zu konzentrieren, welche bei Montage stärkste Biegungen erfahren müssen.

In einer Ausführungsform sind die ersten Elektrodenabschnitte aus einem anderen Material gebildet sind als die zweiten Elektrodenabschnitte. Die Wahl eines leitenden, leicht verformbaren Materials für die zweiten Elektrodenabschnitte verbessert die Flexibilität der Elektrode weiter. Da es in diesen Bereichen nur nachgeordnet auf die kapazitive Sensitivität ankommt, können die zweiten Abschnitte z.B. auch aus leitendem Kunststoff oder einem ein- oder mehradrigen Flachkabel bestehen, welches entlang einer Anordnung von breiten Abschnitten (z.B. Metallplatten) in Kontakt mit diesen gebracht wird (z.B. aufgelegt oder gelötet) und anschließend umspritzt, getaucht oder eingeschrumpft wird.

Es ist besonders vorteilhaft, wenn die Ummantelung in einigen der Abschnitte geringerer Elektrodenbreite Einschnürungen aufweist, z.B. seitliche Kerbungen oder Stanzungen. Diese Einschnürungen können vorteilhaft genutzt werden, um die länglichen Elektroden an diesen Positionen mit Haltemitteln am Fahrzeug zu befestigen (z.B. mit Halteschlaufen, Klammern, Clips). Durch die Halterung in den Einschnürungen ist die Elektrode gegen Verschiebung entlang der Längsachse gesichert. Die Einschnürungen oder Stanzungen verbessern die Flexibilität in diesen Abschnitten weiter. Die Einschnürungen können bei allen Abschnitten mit geringerer Elektrodenbreite ausgeführt sein oder auch nur bei einigen der schmaleren Elektrodenabschnitte.

Weitere vorteilhafte und/oder bevorzugte Ausführungsformen sind in den Unteransprüchen gekennzeichnet.

Die Erfindung wird nun anhand der beiliegenden Figuren näher erläutert.
Figur 1 zeigt die Anordnung einer Ausführungsform der erfindungsgemäßen Sensoranordnung an einem Kraftfahrzeug;
Figur 2 zeigt die Anordnung aus Figur 1 in einer schematischen Aufsicht;
Figuren 3a-3c zeigen eine erste Ausführungsform einer erfindungsgemäßen Sensorelektrodenanordnung;
Figuren 4a-4b zeigen eine zweite Ausführungsform einer erfindungsgemäßen Sensorelektrodenanordnung;
Figur 5a zeigt eine erfindungsgemäße Elektrode zum Einsatz an einem Kraftfahrzeug;
Figur 5b zeigt ein schematisches Ersatzschaltbild der Elektrode aus Figur 5a;

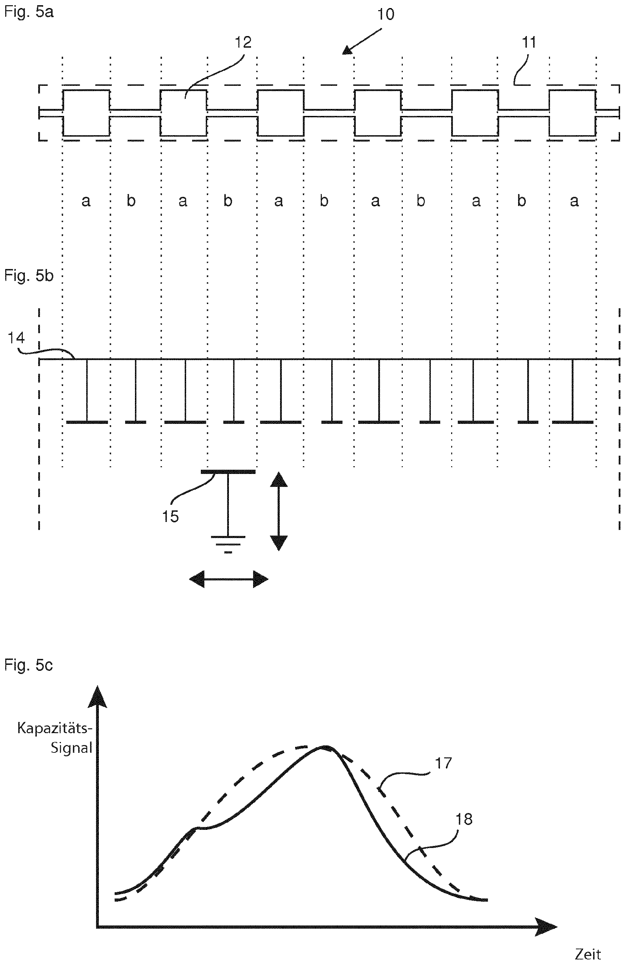

Figur 5b zeigt einen schematischen Signalverlauf bei Detektion einer Betätigungsgeste;

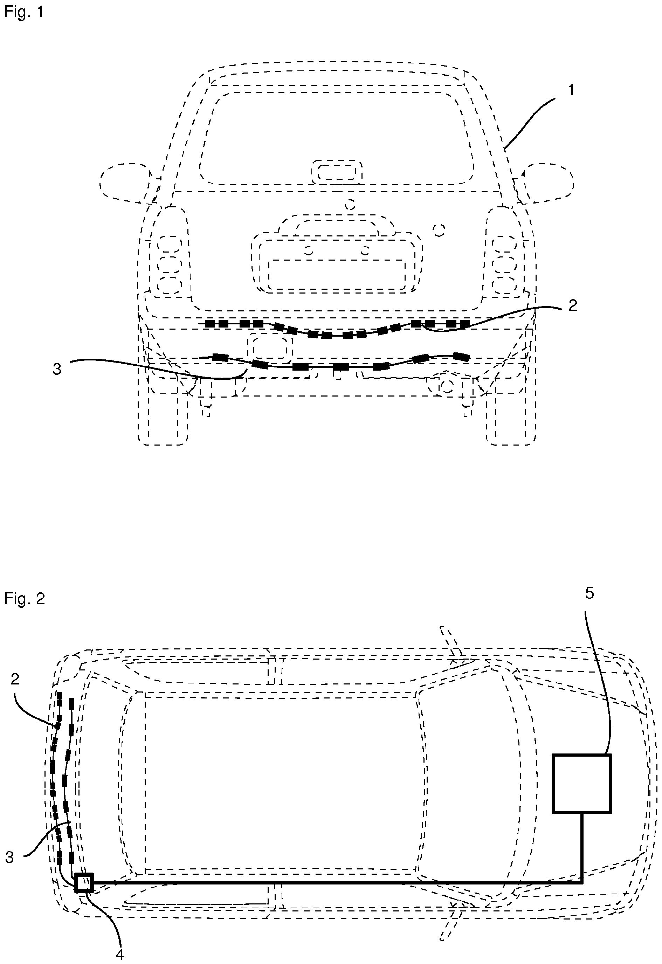

In Figur 1 ist das Heck eines Fahrzeugs 1 gezeigt. Bereich des Heckstossfängers ist eine erfindungsgemäße Sensorelektrodenanordnung 2 angebracht. Unterhalb der Sensorelektrodenanordnung 2 ist eine weitere erfindungsgemäße Sensorelektrodenanordnung 3 mit einem vertikalen und horizontalen Versatz angeordnet. Die Sensorelektrodenanordnungen 2 und 3 sind mit einer Steuer- und Auswerteeinrichtung 4 verbunden. Diese ist nahe der Elektroden 2 und 3 angeordnet. Die Einrichtung 4 ist wiederum mit einer zentralen Fahrzeugsteuereinheit 5 gekoppelt (siehe Figur 2). Die zentrale Steuereinrichtung 5 erhält von der Steuer- und Auswerteeinrichtung 4 ein Signal zur Öffnung der Heckklappe, wobei die Einrichtung 4 die Signale der Elektroden auswertet. Die Elektroden werden auch über diese Steuer- und Auswerteeinrichtung 4 aufgeladen und deren Kapazitätsänderung bei Annäherung eines Körpers, z.B. eines Bedienerkörperteils wird durch Ladungsauswertung erfasst. Dieses Prinzip eines kapazitiven Sensors ist im Bereich der Kraftfahrzeugtechnik bekannt. Der Verbund aus Elektroden 2, 3 und Steuer- und Auswerteeinrichtung absolviert also die Erfassung und Auswertung von Signalen selbstständig und liefert ein Öffnungssignal.

Die Sensorelektrodenanordnung 3 verläuft im Wesentlichen parallel zu der Sensorelektrodenanordnung 2. Die Ausbildung ist derart, dass die Sensorelektrodenanordnungen 2 und 3 in Richtung der Erstreckung des Stoßfängers Bereiche mit wechselnder Erfassungssensitivität aufweist. Dafür sind die Elektroden der Sensorelektrodenanordnungen abschnittsweise mit verschiedener Breite der Flachseiten ausgebildet. Bereiche größerer Breite der Flachseiten werden durch Bereiche geringerer Breite leitend verbunden. Die Elektroden sind als Flachleiter ausgebildet und weisen in diesem Beispiel über die gesamte Länge eine einheitliche Dicke auf. Die flächigen Seiten sind in Richtung des Erfassungsbereiches der Elektroden ausgerichtet. Die Elektrode 2 ist mit ihrer Flachseite nach hinten, die Elektrode 3 nach unten oder schräg hinten-unten gerichtet. In diesem Beispiel weisen die Elektroden 2 und 3 unterschiedliche Abstände zwischen den sensitiveren Bereichen auf und die sensitiven Bereiche sind außerdem bei Elektrode 2 länger als bei Elektrode 3.

Dank ihrer Flexibilität sind die Elektroden an die Karosserieform des Fahrzeuges problemlos anpassbar und z.B. innen an den Stossfänger mit Klebemitteln oder Clips befestigbar.

Die Sensorelektrodenanordnungen 2 und 3 können sowohl eine Annäherung erfassen (durch absolute Veränderung des erfassten Signals) als auch eine Bewegung eines Körpers entlang der Abschnitte unterschiedlicher Breite. Befindet nämlich ein Körper derart vor der Sensorelektrode, dass mehr Fläche oder breitere Abschnitte mit höherer Erfassungssensitivität hinter Körper liegen als Segmente mit niedrigerer Erfassungssensitivität ist das ermittelte Signal höher als in dem Fall, dass der Körper derart vor der Sensorelektrode angeordnet ist, dass schmalere oder verjüngte Abschnitte mit geringerer Erfassungssensitivität hinter Körper liegen (siehe unten). Bewegt sich der Körper entlang der Anordnung, ist dies durch eine Signalfluktuation, insbesondere Wendepunkte im Signalverlauf erkennbar, welche mit der Auswerteeinrichtung messbar sind.

Die Abschnitte unterschiedlicher Breite sollten in ihrer Längsabmessung auf die gewünschte Erfassungsgenauigkeit und die erforderliche Flexibilität abgestimmt sein, sie können z.B. jeweils eine Länge von 0,5cm bis 30cm aufweisen.

Bei einem Bedienerwunsch kann ein Bediener bspw. seinen Unterschenkel in einer Schwenkbewegung unter den Stossfänger bewegen. Diese Bewegung und Annäherung wird sowohl durch die Sensorelektrode 2, als auch durch die Sensorelektrode 3 erfasst, wobei die Kapazitätsänderung zeitlich wiederholt, z.B. mit einer Kapazitätsermittlung alle 5ms-15ms, abgefragt und die Veränderung ausgewertet wird.

Ein Öffnungskommando wird jedoch nur von der Steuereinrichtung 4 generiert, wenn die Sensorelektrodenanordnungen 2, 3 bei zeitlicher Abfrage nicht eine Querbewegung registrieren, welche oberhalb einer zulässigen Schwelle liegt. Es soll nämlich nur eine gerade, auf das Fahrzeug gerichtete Geste als Öffnungskommando interpretiert werden. Demnach wird die Gesamtheit der erfassten Signale ausgewertet, um eine sichere Interpretation einer Öffnungsgeste zu ermöglichen.

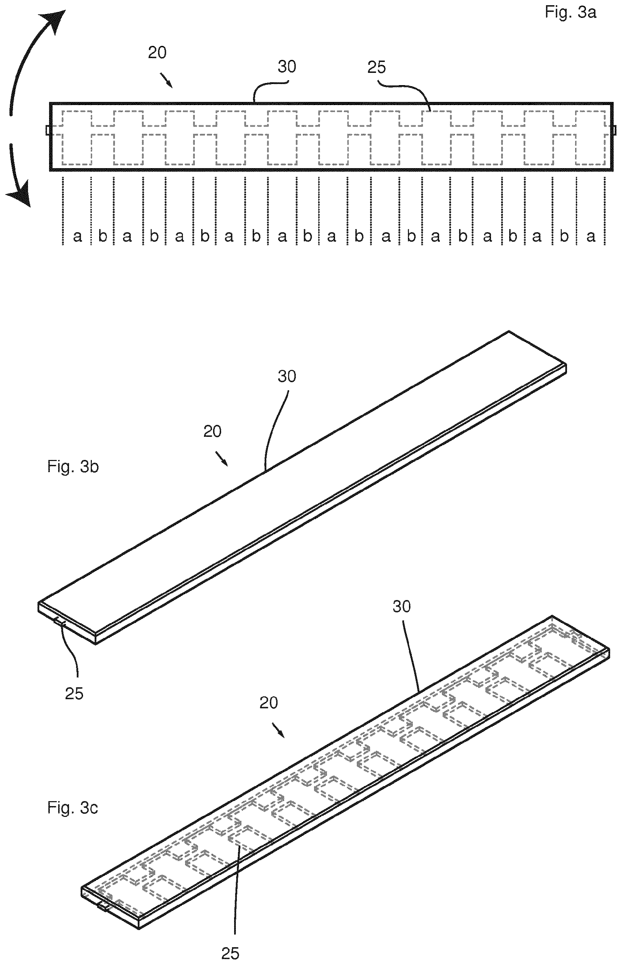

Figur 3A zeigt eine erste Ausführungsform einer Sensorelektrode 20 gemäß der Erfindung. Bei dieser Elektrodenanordnung ist durch ein Extrusionsverfahren eine längliche gestanzte metallische Elektrode 25 mit breiteren (a) und schmaleren (b) Bereichen ausgebildet und von einem flexiblen Kunststoffmaterial 30 ummantelt worden. Es ist ein gegenüber der Umwelt isolierter Streifen 20 gebildet, der sich verformen und mit einer Flachseite an der Innenseite eines Stoßfängers befestigen lässt. Wie in Figur 3A durch die Pfeile schematisch angedeutet, hat diese besondere Ausführungsform durch die Versetzung des Steges, welcher die breiten Elektrodenbereiche verbindet, gegenüber der zentralen Achse eine bevorzugte Biegerichtung. In Richtung des längeren Pfeiles ist eine größere Verformung möglich als in Richtung des kürzeren Pfeiles, da bei Biegeverformungen die benachbarten breiteten Bereiche sich annähern.

Die Streifenelektrode ist selbstverständlich senkrecht zu den einander abgewandten Flachseiten (also senkrecht zur Papierebene in der Abbildung 3a) ebenfalls biegbar, in diesen Richtungen setzt die Elektrode ohnehin der Verformung keine großen Kräfte entgegen.

Die metallische Elektrode 25 selbst ist an den Seiten aus dem Kunststoffmaterial 30 zur Kontaktierung herausgeführt (siehe Figur 3b). Grundsätzlich sind beliebige Geometrien der Elektrode möglich, es ist nicht erforderlich, eckige Konturen auszubilden. Beispielsweise können auch wellenartige Elektrodenbegrenzungen oder kurvenförmige Elektrodenbegrenzungen beliebiger Art gewählt werden, solange die Elektrodenabschnitte geringer Breite und größerer Breite aufweist.

In Figur 3b ist der Streifen mit der Sensorelektrode schematisch gezeigt. Hier wird deutlich, dass durch einfaches Auftragen eines Klebstoffes oder Klebbandes auf einer Seite der Elektrodenanordnung eine problemlose Befestigung an der Innenseite des Fahrzeuges möglich ist, da eine ebene und zugängliche isolierende Ummantelungsfläche zur Befestigung zur Verfügung steht.

Die Lage der leitenden Elektrodenseele in der Ummantelung ist in Figur 3C nochmals schematisch dargestellt.

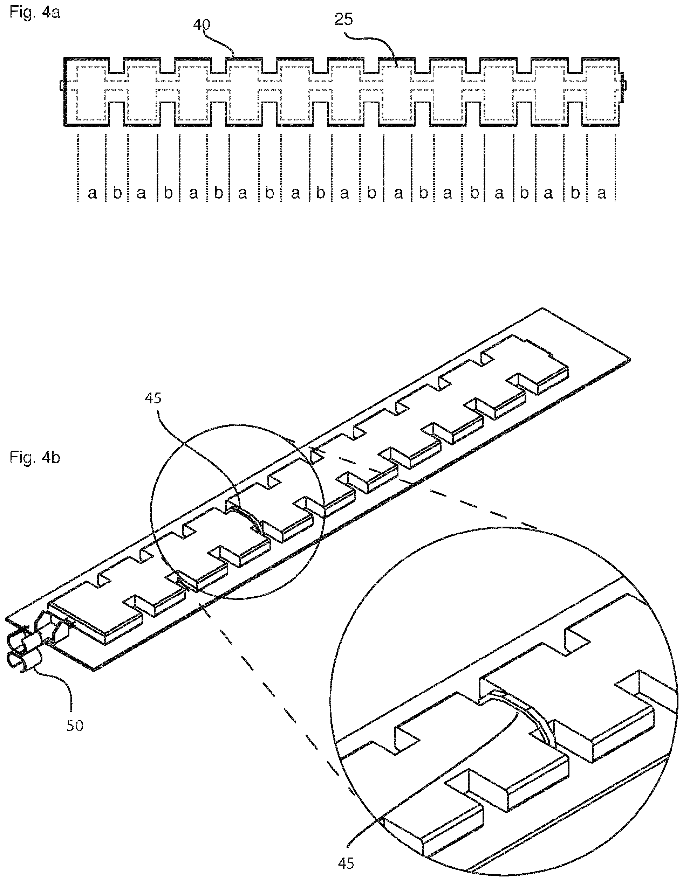

Figur 4a zeigt eine Weiterbildung der vorstehend erläuterten Elektrodenform. Hier ist die flexible Kunststoff-Ummantelung 40 in den Bereichen (b) mit verjüngtem Elektrodenquerschnitt gekerbt, um eine noch bessere Flexibilität zu ermöglichen und gleichzeitig Bereiche für die Befestigung der Elektrode zu bilden.

Wie in Figur 4b dargestellt, kann in solchen Bereichen durch einen Kabelbinder (45) oder einen Clip die Elektrode fixiert werden, wobei diese gleichzeitig gegen Längsverschiebungen gesichert ist. Durch die Ausnehmung wird zusätzlich Gewicht reduziert und durch unterschiedlich starke oder tiefe Auskerbungen an den einander abgewandten Seiten kann die Vorzugsbiegerichtung kenntlich gemacht werden. In dieser Darstellung ist an einem einseitig austretenden Elektrodenende außerdem eine Steckerkontaktierung 50 angebracht, welche beispielsweise mittels einer Crimpverbindung an die von einer Elektrodenrolle abgeschnittene Sensorelektrode fixiert werden kann. Dazu wird die Elektrodenanordnung mit Ummantelung als Rollenware hergestellt, auf Länge gekürzt, so dass eine Trennung an einem a-b Übergang stattfindet und das schmale Elektrodenstück (b-Abschnitt) wird von Ummantelung befreit und gecrimpt. Die hier dargestellte Steckverbindung weist zwei gekoppelte Klemmverbinder auf, insbesondere um eine Gesteckt-Kontrolle zu ermöglichen. Ein mit dem Steuergerät verbundener Stecker 50 kann durch Widerstandskontrolle oder Spannungskontrolle zwischen beiden Kontakten prüfen, ob der Stecker ordnungsgemäß mit der Elektrode verbunden ist.

In Figur 5a ist ein Abschnitt einer erfindungsgemäßen Sensorelektrode 10 gezeigt. Eine verformbare Ummantelung 11 aus einem elastischen Material ist gestrichelt dargestellt. In der Ummantelung 11 ist die eigentliche Sensorelektrode 12 als durchgehender elektrischer Leiter angeordnet. Die Sensorelektrode 12 weist Bereiche a mit erhöhter Breite quer zur Längsrichtung und Bereiche b mit verringerter Breite oder Verjüngung quer zur Längsrichtung auf. Die Dicke der Sensorelektrode, also die Erstreckung senkrecht zu der Papierebene, ist in diesem Ausführungsbeispiel über die gesamte Elektrodenlänge identisch. Die Sensorelektrode 12 ist entsprechend durch Stanzen oder Lasern aus einem homogenen Flachleitermaterial erstellt. Alternativ kann ein Flexleiter verwendet werden, um die Elektrode in der erfindungsgemäßen Weise auszubilden. An einem ihrer Enden ist die Sensorelektrode kontaktiert, um mit dem Steuergerät 4 verbunden zu werden.

Zur Verdeutlichung der Funktionsweise ist ein Ersatzschaltbild in Figur 5b gezeigt, welche entlang der Längserstreckung eine Kondensatorplattenanordnung 14 als Modellvorstellung zeigt, die miteinander elektrisch leitend verbundene Kondensatorplatten mit unterschiedlicher Fläche aufweist. Den Bereichen a ist eine Kondensatorplatte mit größerer Fläche zugeordnet und den Bereichen b eine Kondensatorplatte mit kleinerer Fläche. Die Darstellung in Figur 5b dient lediglich dem Verständnis und stellt keine bauliche Gestaltung der Erfindung dar. Es wird jedoch klar, dass bei kapazitiver Kopplung einer beweglichen Kondensatorplatte 15, welche sowohl in Richtung auf die fixierten Kondensatorplatten hin bewegbar ist, als auch seitlich zu diesen bewegbar ist, eine kapazitive Veränderung in der Kondensatoranordnung hervorzurufen ist. Die Kondensatorplatte 15 steht dabei für einen Körperteil eines Bedieners, z. B. den Unterschenkel, welcher sich der Elektrodenanordnung 10 bzw. der Kondensatorplattenanordnung 14 annähert. Je nachdem, welcher Kondensatorfläche der Kondensatorplatte 15 gegenüberliegt, ist eine unterschiedliche Kapazitätsänderung des aus der Anordnung 14 und der Platte 15 gebildeten Kondensators zu erwarten. Bewegt sich die Kondensatorplatte 15 außerdem entlang der Längsrichtung der Elektrode, so liegt er zeitweise einem Kondensator mit geringerer Fläche (in einem Abschnitt b) oder einer Platte mit größerer Fläche (in Abschnitt a) gegenüber. Selbstverständlich liegen in der Realität jederzeit Mischzustände vor. Bewegt sich jedoch die Kondensatorplatte 15 ohne Abstandsänderung zu den gegenüberliegenden Kondensatoranordnungen quer zu diesen von einer Kondensatorplatte mit großer Fläche über eine Kondensatorplatte mit kleinerer Fläche hin zu einer Kondensatorplatte mit wiederum großer Fläche (also von Bereich a über Bereich b zu dem nächsten Bereich a), so wird das Signal, d. h. die Kapazität von einem Maximum über ein Minimum wieder zu einem Maximum ansteigen.

In der Praxis überlagert sich einer herauszufilternden Querbewegung oft noch eine Annäherung auf die Elektrode zu oder von dieser weg. Erkennbar wird eine solche Querbewegung bei der erfindungsgemäßen Elektrode durch Betrachtung des Signalverlaufs.

Dazu zeigt Figur 5c einen beispielhaften Signalverlauf. Der gestrichelt dargestellte Signalverlauf 17 zeigt eine ausschließlich auf die Sensorelektrode in senkrechter Weise hin ausgeführte Bewegung und Rückbewegung, wobei die Kapazitätsänderung auf einen Maximalwert ansteigt (bei maximaler Annäherung) und danach wieder abfällt. Ist dieser Bewegung auf die Elektrode zu einer Querbewegung überlagert, so ergibt sich ein (hier normalisiert dargestellter) Signalverlauf 18, der im Signalverlauf, genauer im Signalanstieg selbst einen Wendepunkt aufweist. Dieser Wendepunkt resultiert daraus, dass von dem Unterschenkel eines Benutzers die Bewegung derart vollzogen wird, dass der Körper zu verschiedenen Zeiten in unterschiedlichen Anteilen in den jeweiligen Abschnitten a oder b vorliegt, sich also quer zu Elektrodenanordnung bewegt. Der Betätigungskick, sofern es überhaupt ein gezielter Betätigungsversuch ist, wird seitlich ausgeführt. Beim Übergang von einem Abschnitt a mit hoher Erfassungssensibilität zu einem Abschnitt b wird trotz der Annäherung des Körpers an die Elektrode allein aufgrund der geringeren Flächenkopplung ein Wendepunkt im Signalverlauf entstehen. Selbst wenn der Maximalwert des Signales genauso erreicht wird, wie bei einer perfekt senkrecht ausgeführten Bewegung, ist die Quererkennung anhand der erfindungsgemäßen ausgebildeten Elektrode detektierbar. Dazu ist lediglich eine Erfassung der Kapazitäten mit ausreichender Zeitauflösung erforderlich, was jedoch nach heutigem Stand der Technik möglich ist. Wird eine solche Signalform ermittelt, so kann die Signalfolge als ungezielte Bewegung verworfen werden. Dabei können selbstverständlich weitere Kriterien, wie z.B. absolute Signalstärke, Extremwerte etc. berücksichtigt werden. Wesentlich ist, dass die erfindungsgemäße Anordnung eine solche differenzierte Auswertung überhaupt erlaubt.

## Patentansprüche

1. Sensoranordnung zur kapazitiven Erfassung von Annäherungen an einem Kraftfahrzeug (1), mit einer kapazitiven Sensorelektrode (2, 3; 25) und wenigstens einer mit der Sensorelektrode gekoppelten Steuer- und Auswerteeinrichtung (4), die eine Änderung der Kapazität der Sensorelektrode erfasst, wobei die Sensorelektrode (2, 3; 25) als langgestreckte Flachelektrode ausgebildet ist,
wobei sich bei der Sensorelektrode (2, 3; 25) in Längsrichtung der Sensorelektrode erste Elektrodenabschnitte (a) mit einer ersten Flächenbreite und ersten Verformbarkeit mit zweiten Abschnitten (b) einer zweiten, geringeren Flächenbreite und zweiten, größeren Verformbarkeit abwechseln, so dass abschnittsweise durchgehend leitende und verbundene, jedoch unterschiedlich verformbare Elektrodenflächen mit unterschiedlichen Abmessungen gebildet sind,
**dadurch gekennzeichnet,**
**dass** eine verformbare und elektrisch isolierende Ummantelung (30; 40) der Sensorelektrode ausgebildet ist, wobei die Sensorelektrode abwechselnde Bereiche mit paarweise einheitlichen Abmessungen aufweisen, so dass alle breiteren Abschnitte einheitlich ausgebildet sind und alle schmaleren Abschnitte einheitlich ausgebildet sind und wobei die zweiten Abschnitte eine geringere Länge aufweisen als die ersten Abschnitte.

2. Sensoranordnung nach Anspruch 1, wobei die Sensorelektrode entlang ihrer Längserstreckung mit einheitlicher Elektrodendicke ausgebildet ist.

3. Sensoranordnung nach Anspruch 1, wobei die Sensorelektrode entlang ihrer Längserstreckung aus einheitlichem Elektrodenmaterial ausgebildet ist.

4. Sensoranordnung nach Anspruch 1, wobei die ersten Elektrodenabschnitte aus einem anderen Material gebildet sind als die zweiten Elektrodenabschnitte.

5. Sensoranordnung nach Anspruch 1, wobei die gesamte Sensorelektrode mit ersten und zweiten Abschnitten integral ausgebildet ist.

6. Sensoranordnung nach Anspruch 4, wobei die zweiten Elektrodenabschnitte aus einem Material mit geringerem Verformungswiderstand gebildet sind, vorzugsweise aus einem leitfähigen Kunststoff- oder Textilmaterial.

7. Sensoranordnung nach einem der vorangehenden Ansprüche, wobei die Ummantelung aus einem elastischen Material gebildet ist und wobei Markierungen auf der Ummantelung angeordnet sind, welche die sensitiveren und weniger sensitiven Bereiche der innenliegenden Elektrode anzeigen.

8. Sensoranordnung nach einem der vorangehenden Ansprüche, wobei die Ummantelung der Sensorelektrode in wenigstens einigen der zweiten Bereiche Einschnürungen aufweist, welche zur Aufnahme von Befestigungsmitteln ausgebildet sind.

9. Sensoranordnung nach einem der vorangehenden Ansprüche, wobei die verbindenden zweiten Elektrodenabschnitte zwischen den ersten Elektrodenabschnitten entlang der Richtung der Längserstreckung axial versetzt, also senkrecht zur Längserstreckung und zu einer der seitlichen Begrenzungen der Flachelektroden verschoben, angeordnet sind.

## Claims

1. A sensor arrangement for capacitive detection of approaches on a motor vehicle (1), having a capacitive sensor electrode (2, 3; 25) and at least one control and evaluation device (4) coupled to the sensor electrode, which detects a change in the capacitance of the sensor electrode, the sensor electrode (2, 3; 25) being constructed as an elongated flat electrode,
first electrode sections (a) with a first surface width and first deformability alternating with second sections (b) of a second, lower surface width and second, larger deformability, in the sensor electrode (2, 3; 25) in the longitudinal direction of the sensor electrode, so that in certain sections, continuously conductive and connected, but differently deformable electrode surfaces with different dimensions are formed,
**characterized**
**in that** a deformable and electrically insulating jacket (30; 40) of the sensor electrode is constructed, wherein the sensor electrode has alternating regions with uniform dimensions in pairs, so that all wider sections are constructed uniformly and all narrower sections are constructed uniformly and wherein the second sections have a smaller length than the first sections.

2. The sensor arrangement according to claim 1, wherein the sensor electrode is constructed with a uniform electrode thickness along its longitudinal extent.

3. The sensor arrangement according to claim 1, wherein the sensor electrode is constructed from a uniform electrode material along its longitudinal extent.

4. The sensor arrangement according to claim 1, wherein the first electrode sections are formed from a different material than the second electrode sections.

5. The sensor arrangement according to claim 1, wherein the entire sensor electrode is constructed integrally with first and second sections.

6. The sensor arrangement according to claim 4, wherein the second electrode sections are formed from a material with a smaller deformation resistance, preferably from a conductive plastic or textile material.

7. The sensor arrangement according to one of the preceding claims, wherein the jacket is formed from an elastic material and wherein markings are arranged on the jacket, which display the more sensitive and less sensitive regions of the internal electrode.

8. The sensor arrangement according to one of the preceding claims, wherein the jacket of the sensor electrode has constrictions in at least a few of the second regions, which are constructed for accommodating fastening means.

9. The sensor arrangement according to one of the preceding claims, wherein the connecting second electrode sections are arranged between the first electrode sections axially offset along the direction of the longitudinal extent, that is to say perpendicularly to the longitudinal extent and shifted to one of the lateral boundaries of the flat electrodes.

## Revendications

1. Ensemble capteur pour la saisie capacitive d'approches au niveau d'un véhicule automobile (1) avec une électrode de capteur capacitive (2, 3 ; 25) et au moins un système de commande et d'exploitation (4) couplé à l'électrode de capteur, qui saisit une variation de la capacité de l'électrode de capteur, sachant que l'électrode de capteur (2, 3 ; 25) est constituée comme une électrode plate allongée,
sachant que concernant l'électrode de capteur (2, 3 ; 25) des premières sections d'électrode (a) avec une première largeur de surface et une première déformabilité alternent dans la direction longitudinale avec des deuxièmes sections (b) d'une deuxième largeur de surface plus faible et une deuxième déformabilité plus importante de telle manière que des surfaces d'électrode conductrices et reliées de façon partiellement continue, toutefois différemment déformables, sont formées avec des dimensions différentes,
**caractérisé**
**en ce qu'**une enveloppe (30 ; 40) déformable et électriquement isolée de l'électrode de capteur est constituée, sachant que l'électrode de capteur comporte des zones alternatives avec des dimensions homogènes par paires de telle sorte que toutes les sections plus larges sont constituées de façon homogène et toutes les sections plus étroites sont constituées de façon homogène et sachant que les deuxièmes sections comportent une longueur plus faible que les premières sections.

2. Ensemble capteur selon la revendication 1, sachant que l'électrode de capteur est constituée le long de son extension longitudinale avec une épaisseur d'électrode homogène.

3. Ensemble capteur selon la revendication 1, sachant que l'électrode de capteur est constituée le long de son extension longitudinale dans un matériau d'électrode homogène.

4. Ensemble capteur selon la revendication 1, sachant que les premières sections d'électrode sont formées dans un autre matériau que les deuxièmes sections d'électrode.

5. Ensemble capteur capacitif selon la revendication 1, sachant que l'électrode de capteur complète est constituée intégralement avec des premières et des deuxièmes sections.

6. Ensemble capteur selon la revendication 4, sachant que les deuxièmes sections d'électrode sont formées d'un matériau avec une résistance à la déformation plus faible, de préférence d'une matière plastique ou textile conductrice.

7. Ensemble capteur selon l'une quelconque des revendications précédentes, sachant que l'enveloppe est formée d'un matériau élastique et sachant que des repères sont disposés sur l'enveloppe, lesquels indiquent les zones plus sensibles et moins sensibles de l'électrode se trouvant à l'intérieur.

8. Ensemble capteur selon l'une quelconque des revendications précédentes, sachant que l'enveloppe d'électrode de capteur comporte dans au moins plusieurs des deuxièmes zones des constrictions, lesquelles sont constituées pour recevoir des moyens de fixation.

9. Ensemble capteur selon l'une quelconque des revendications précédentes, sachant que les deuxièmes sections d'électrode raccordantes sont disposées axialement déportées entre les premières sections d'électrode le long de la direction de l'extension longitudinale, donc déplacées perpendiculairement à l'extension longitudinale et à une des limites latérales des électrodes plates.
